# EUROPEAN PATENT SPECIFICATION

(11) **EP 0 782 201 B1**
(45) Date of publication and mention of the grant of the patent: **30.08.2000**
(21) Application number: 95830542.7
(22) Date of filing: 28.12.1995
(51) Int. Cl.: H01L 29/78, H01L 29/739, H01L 29/423, H01L 29/417, H01L 23/482, H01L 29/10, H01L 29/06

(54) **MOS-technology power device integrated structure**
MOS-Technologie-Leistungsanordnung in integrierter Struktur
Structure intégrée d'un dispositif de puissance en technologie MOS

(43) Date of publication of application: 02.07.1997
(73) Proprietor: STMicroelectronics S.r.l., 20041 Agrate Brianza (Milano) (IT); Consorzio per la Ricerca sulla Microelettronica nel Mezzogiorno, 95121 Catania (IT)
(72) Inventor: Grimaldi, Antonio, I-95030 Mascalucia (Catania) (IT); Schillaci, Antonino, I-98100 Messina (IT); Frisina, Ferruccio, I-95030 Sant'Agata li Battiati (Catania) (IT); Ferla, Giuseppe, I-95126 Catania (IT)
(74) Representative: Mittler, Enrico

(56) References cited:
- EP-A- 0 237 932
- EP-A- 0 685 886
- FR-A- 2 640 081
- US-A- 5 208 471
- US-A- 5 286 984
- PATENT ABSTRACTS OF JAPAN vol. 014, no. 387 (E-0967), 21 August 1990 & JP-A-02 143566 (TOSHIBA CORP), 1 June 1990,

## Description

The present invention relates to a MOS-technology power device integrated structure.

MOS-technology power devices feature dynamic performances suitable for applications wherein high currents at high voltages are switched on and off in times of some hundred nanoseconds.

There is therefore the need of devices capable of handling such high power levels in extremely short times.

In order to achieve high channel perimeter lengths per unit area, MOS-technology power devices currently available are made up of several millions elementary cells with square or hexagonal shape. It is thus possible to keep the on-state resistance Ron (output resistance) of the power device low, thus limiting the voltage drop across the power device when the latter is in the on state. The elementary cells form elementary vertical MOSFETs, and include a body region, for example of P type, formed in a lightly doped N type semiconductor layer representing the common drain of the power device; an N type source region is formed inside the body region.

The dynamic performance of cellular MOS-technology power devices is however limited by the presence of parasitic capacitances and by the relatively high gate resistance. In addition to this, the maximum reverse voltage that can be applied to the body-drain junction is limited by the fact that the body region of the elementary cells form, in the common drain layer wherein they are formed, spherical PN junctions, and by the reduced efficiency of the edge structures.

These problems are exhacerbated by the fact that interruptions in the regular array of elementary cells are to be provided, essentially for the following two reasons. Firstly, to reduce the gate resistance of the power device it is necessary to have metal strips ("metal gate fingers") crossing the power device chip to contact the polysilicon gate. Secondly, the metal gate fingers must be interrupted in the region of the chip where a source wire is to be bonded. In addition to this, boundary regions of the regular array of elementary cells are to be provided, because in order to increase the breakdown voltage it is necessary to provide an efficient edge structure.

These interruptions or boundary regions introduce asimmetries constituting points of weakness of the power device. In fact, the presence of the metal gate fingers causes the structure not to be uniform, because the distance between adjacent body regions is not constant in the whole active area of the power device chip; at the same time, since the number of metal gate fingers contacting the polysilicon gate must be limited, the distributed gate resistance is highly disuniform, because the elementary cells near the metal gate fingers experinece a significantly lower gate resistance than those far away from the metal gate fingers.

US 5,286,984 discloses a conductivity modulated MOSFET substantially according to the preamble of claim 1.

US 5,208,471 discloses power MOSFET or IGBT having a plurality of P type layers which are long, narrow and juxtaposed with their longitudinal direction oriented in the same direction, and an annular, peripheral P type layer surrounding the plurality of P type layers, while being contiguous to some of the P type layers.

FR 2640081 discloses a vertical field effect transistor with body stripes inside which source regions intercalated with body stripe portions are provided.

In view of the state of the art described, it is an object of the present invention to provide a new MOS-technology power device integrated structure which is less affected by the above-mentioned problems.

According to the present invention, said object is achieved by means of a MOS-technology power device integrated structure as set forth in claim 1.

Thanks to the present invention, a new structure of MOS-technology power device is provided. The MOS-technology power device does not have a cellular structure, because the polygonal elementary cells have been replaced by body stripes. The mesh of the second conductivity type has the function of providing an edge structure (formed by the annular frame region which surrounds all the body stripes) and a structure for the interconnection of the body stripes to each other and of the body stripes to the edge structure. In this way, it is assured that all the body stripes, as well as the edge structure, are at the same electric potential.

The presence of metal gate fingers, extending for example from a metal gate ring surrounding the body stripes (i.e. the active area of the power device chip), allows to reduce the gate resistance of the MOS-technology power device; furthemore, the gate resistance is quite uniform. The presence of the elongated stripes of the second conductivity type under the metal gate fingers improves the dynamic performance of the power device, because in this way a gate-drain(feedback) capacitance is transformed in a gate-source (input) capacitance; this capacitance can be further reduced using thick oxide layers to isolate the conductive gate fingers from the underlying elongated stripes of the second conductivity type.

These and other features and advantages of the present invention will be made more evident by the following detailed description of two particular embodiments, illustrated as non-limiting examples in the annexed drawings, wherein:
Fig. 1 is a schematic top plan view of a MOS-technology power device integrated structure according to a first embodiment of the present invention;
Fig. 2 is a cross-sectional view taken along line II-II in Fig. 1;
Fig. 2A is similar to Fig. 2, but shows a variation of the first embodiment of the invention;
Fig. 3 is a cross-sectional view taken along line III-III in Fig. 1;
Fig. 4 is a cross-sectional view taken along line IV-IV in Fig. 1;
Fig. 5 is a cross-sectional view taken along line V-V in Fig. 1;
Fig. 6 is a cross-sectional view taken along line VI-VI in Fig. 1;
Fig. 7 is a cross-sectional view taken along line VII-VII in Fig. 1;
Figs. 8 to 11 are cross-sectional view taken at intermediate steps of a manufacturing process of the MOS-technology power device integrated structure shown in Fig. 1;
Fig. 12 is a top-plan view similar to Fig. 1, showing the MOS-technology power device integrated structure after the step shown in Fig. 9;
Fig. 13 is a top-plan view similar to Fig. 1, showing the MOS-technology power device integrated structure after the step shown in Fig. 10;
Fig. 14 is a schematic top-plan view of a MOS-technology power device integrated structure according to a second embodiment of the present invention;
Fig. 15 is a perspective view of a portion of the MOS-technology power device shown in Fig. 14;
Fig. 16 is a cross-sectional view along line XVI-XVI in Fig. 14; and
Fig. 17 is a cross-sectional view along line XVII-XVII in Fig. 14.

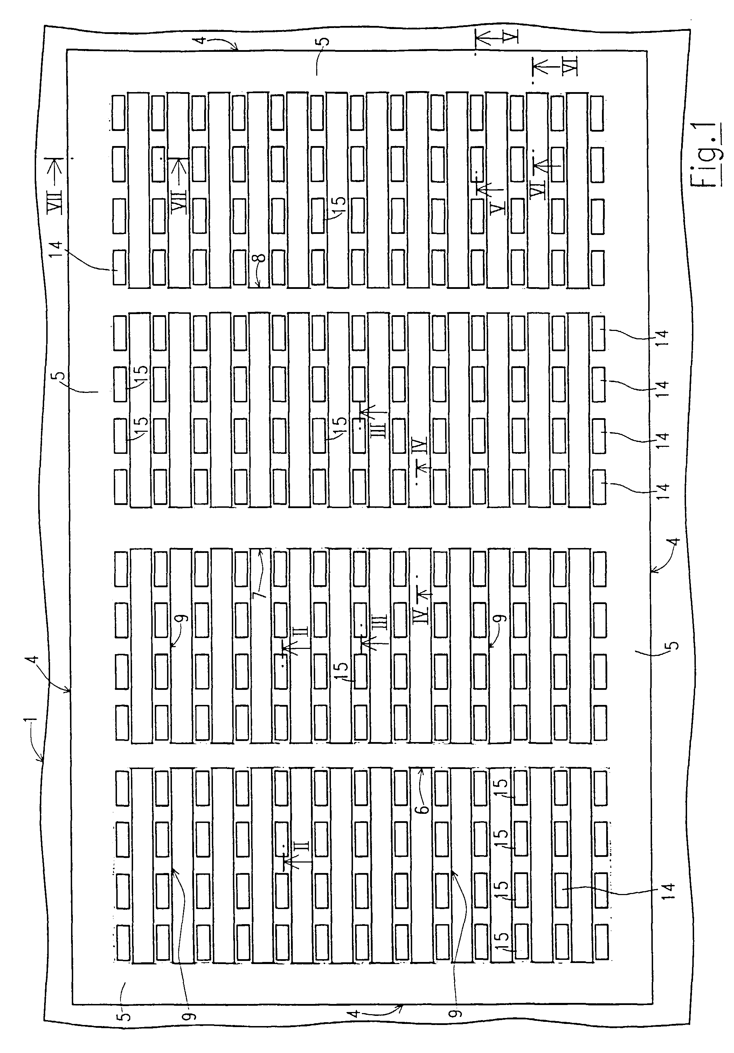

Fig. 1 is a schematic top-plan view of a MOS-technology power device integrated structure according to a first embodiment of the present invention; the reference numeral 1 has been used to generally designate a semiconductor chip containing the MOS-technology power device.

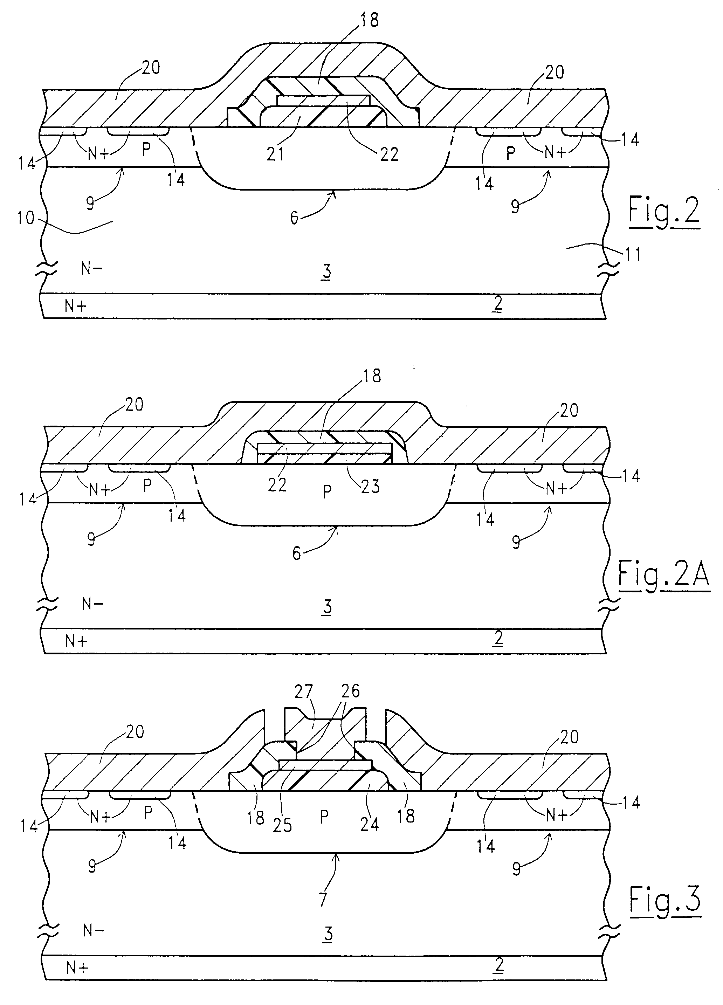

As visible in the cross-sections of Figs. 2 to 7, the chip 1 comprises a heavily doped N+ semiconductor substrate 2, over which a lightly doped N- semiconductor layer 3 is provided. The N- layer 3 forms a common drain layer of the MOS-technology power device. It should be apparent that Fig. 1 represents a top-plan view taken at the level of the top surface of the N-layer 3.

In the N- layer 3 a P type mesh 4 is formed. The P type mesh 4 comprises a P type frame 5, which in the shown example is rectangular but can be a generally annular region. P type elongated stripes 6, 7, 8 formed in the N- layer 3 extend substantially parallely to each other within the P type frame 5, and are merged at their ends with the P type frame 5. As visible in Fig. 1, the P type elongated stripe 7 is wider than the P type elongated stripes 6 and 8, for the reasons that will be explained later on.

P type body stripes 9 formed in the N- layer 3 extend substantially parallely to each other, and substantially orthogonally to the P type elongated stripes 6-8, between the P type frame 5 and one of the P type elongated stripes 6, 7, 8, or between two adjacent ones of said P type elongated stripes 6, 7, 8; the ends of the P type body stripes 9 are merged with the P type frame 5 and with the P type elongated stripes 6, 7, 8. In other words, the P type elongated stripes 6, 7, 8 divide the portion of N- layer 3 circumscribed by the P type frame 5 into four regions 10, 11, 12 and 13 (Fig. 10), and in each one of said regions 10-13 a plurality of substantially parallel P type body stripes 9 is formed in the N- layer 3: in regions 10 and 13 the P type body stripes 9 extend orthogonally between, and are merged at their ends with, the P type frame 5 and the P type elongated stripes 6 and 8, respectively, while in regions 11 and 12 the P type body stripes 9 extend orthogonally between, and are merged at their ends with, the P type elongated stripe 7 and the P type elongated stripes 6 and 8, respectively. Also, the uppermost and lowermost P type body stripes 9 in each one of the regions 10-13 are merged for their whole length with the P type frame 5.

The P type body stripes form elementary functional units of the MOS-technology power device, which contribute for respective fractions to an overall current of the MOS-technology power device. Inside each P type body stripe 9, heavily doped N+ source regions 14 are formed; in the shown embodiment, the N+ source regions are rectangles extending inside the P type body stripes 9 and intercalated by portions of the P type body stripes 9 wherein the N type dopant is absent. The N+ source regions 14 define channel portions 15 of the P type body stripes 9.

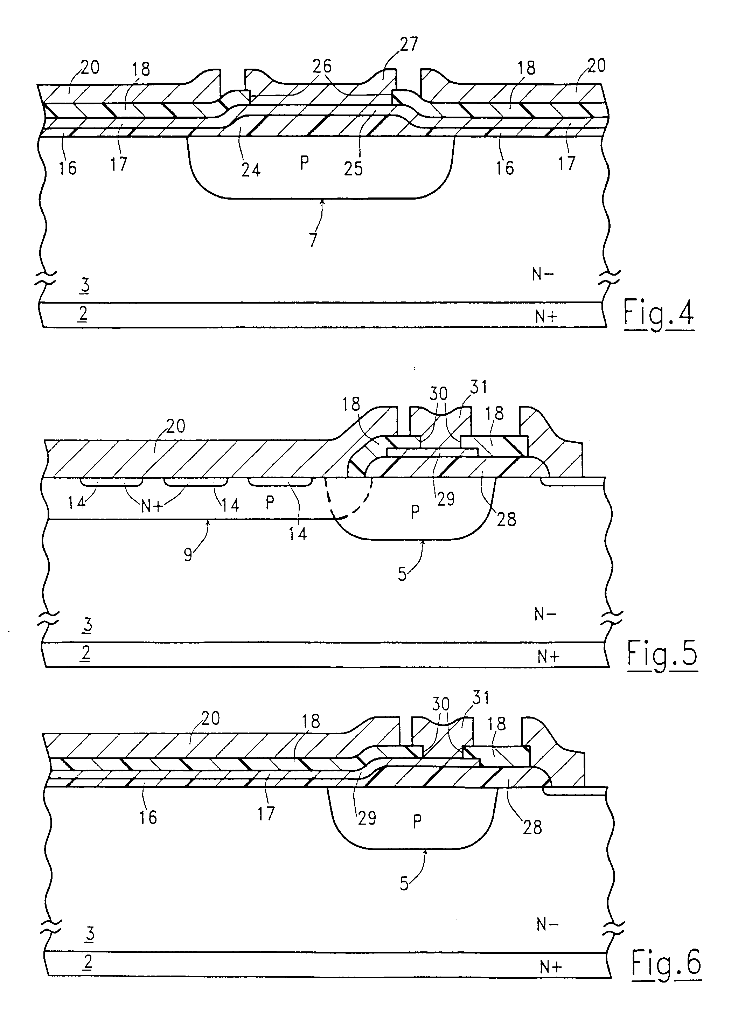

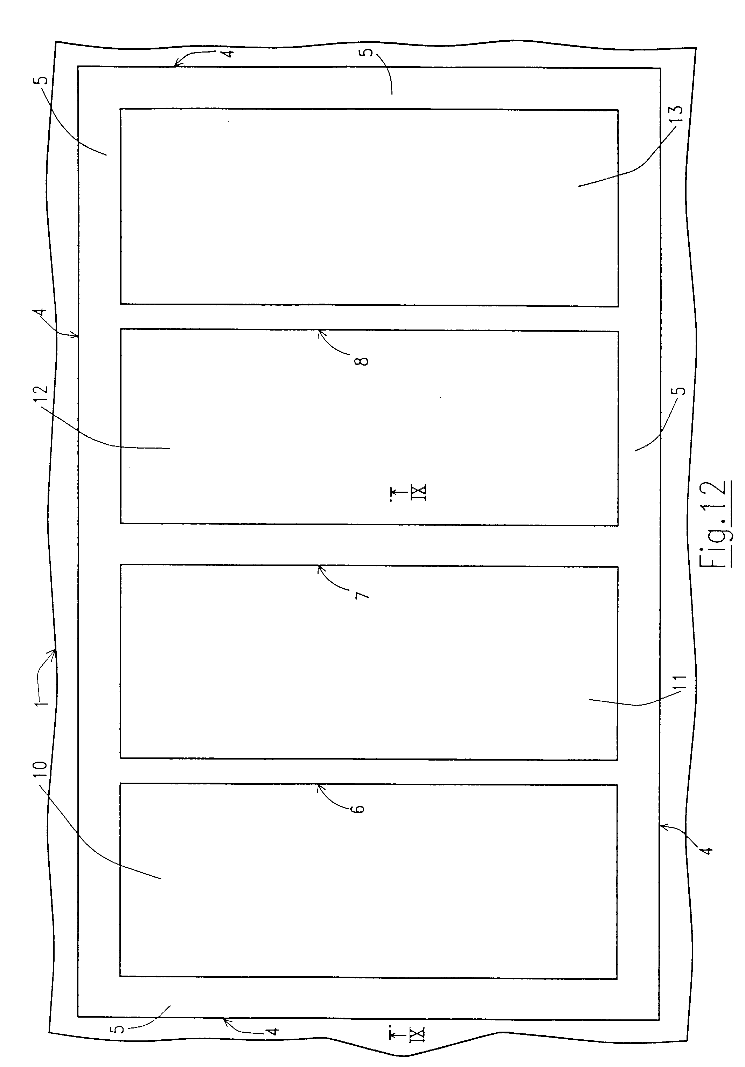

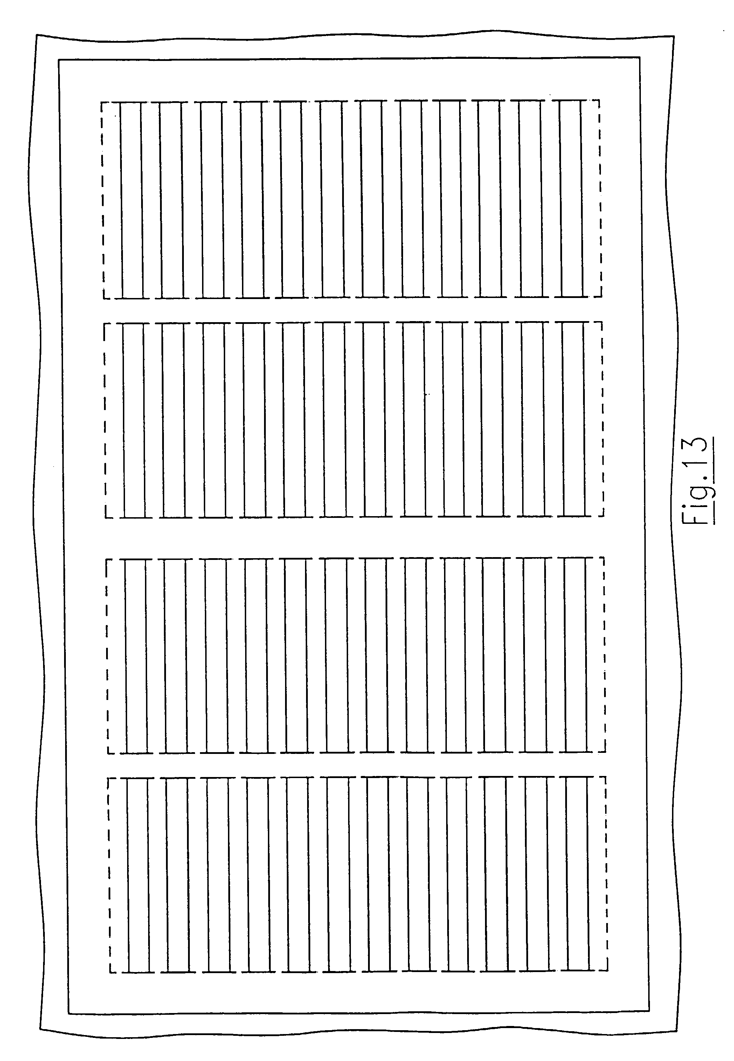

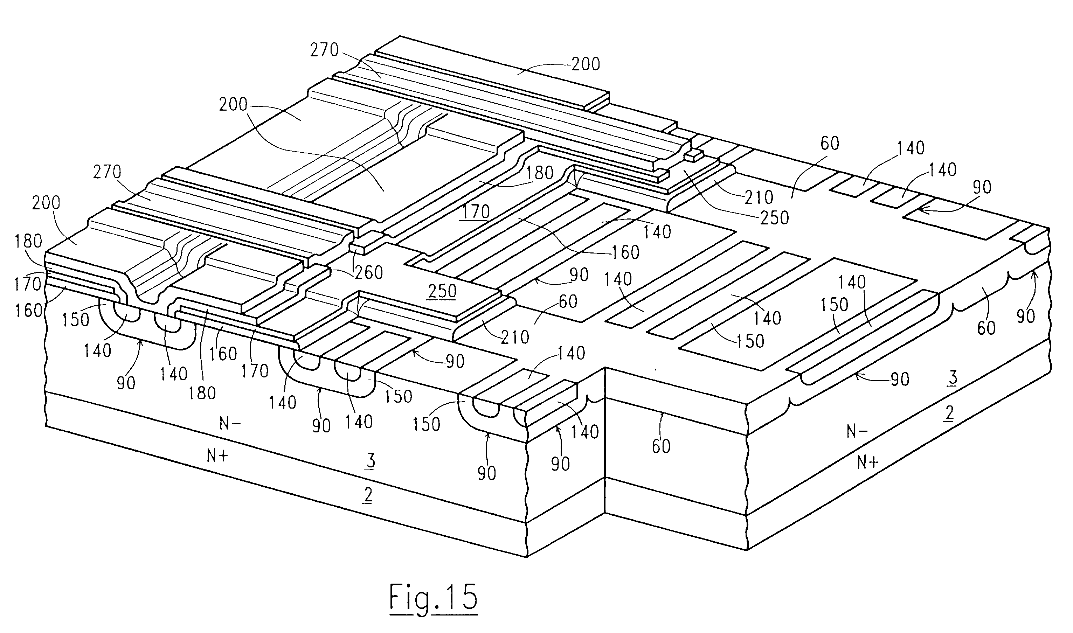

As visible in the cross-sectional views of Figs. 4, 6 and 7, a conductive insulated gate layer comprising a thin gate oxide layer 16 and a polysilicon layer 17 extend over the N-layer 3 between the P type body stripes 9. As clearly visible in Fig. 7, the insulated gate layer, i.e. the gate oxide layer 16 and the polysilicon layer 17, slightly extends over the P type body stripes 9, more precisely they extend over the channel portions 15 defined by the N+ source regions 14. The polysilicon layer 17 forms a gate electrode of the MOS-technology power device, and when a proper bias voltage is applied to the polysilicon layer 17 an inversion channel is formed in the channel portions 15 of the P type body stripes 9.

The polysilicon layer 17 is covered by a dielectric layer 18 in which elongated contact openings 19 are provided over the P type body stripes 9, the elongated contact openings 19 extending substantially for the whole length of the P type body stripes 9. A source metal layer 20 covers the dielectric layer 18 and contacts, through the elongated contact openings 19, the N+ source regions 14 and, where the N+ source regions 14 are absent, the P type body stripes 9. Each one of the regions 10-13 of the N- layer 3 is covered by a respective continuous source metal plate formed by the source metal layer 20.

Fig. 2 shows in cross-section the region of the chip where the P type body stripes 9 are merged with the P type elongated stripe 6. Over the P type elongated stripe 6 a stripe 21 of a thick oxide layer is provided (having thickness approximately equal to two-three times the thickness of the gate oxide layer 16), extending for the whole length of the P type stripe 6. Over the stripe 21 of thick oxide, a stripe 22 of polysilicon layer is provided; the stripe 22 of polysilicon layer is part of the polysilicon layer 17 forming the gate electrode of the MOS-technology power device, and forms a polysilicon gate finger. The polysilicon gate finger 22 is covered by a stripe of dielectric layer 18. The source metal plate covering the region 10 of the N- layer 3 extends over the stripe of dielectric layer 18 which covers the polysilicon gate finger 22, and forms a continuum with the source metal plate covering the adjacent region 11 of the N- layer 3. The same arrangement is provided in the region where the P type body stripes 9 are merged with the P type elongated stripe 8. It is worth noting that the stripe of dielectric layer 18 covering the polysilicon gate finger 22 is narrower than the P type elongated stripe 6, so that the source metal layer 20 can contact the P type elongated stripe 6 along its edges.

Fig. 2A shows a variation of the embodiment wherein the stripe 21 of thick oxide has been replaced by a stripe 23 of the thin gate oxide layer 16. This embodiment, even if it is simpler from a manufacturing viewpoint, is disadvantageous with respect to the embodiment of Fig. 2, because the thinner oxide layer which isolates the polysilicon gate finger from the underlying P type elongated stripe 6 causes an increase in the input capacitance of the power device.

Figs. 3 and 4 show in cross-section the region of the chip where the P type body regions 9 merges with the P type elongated stripe 7. Over the P type elongated stripe 7, a stripe 24 of thick oxide is provided, extending for the whole length of the stripe 7. Over the thick oxide stripe 24, a polysilicon gate finger 25 is provided, which is part of the polysilicon gate layer 17 (Fig. 4). The polysilicon gate finger 25 is covered by a stripe of dielectric layer 18 in which an elongated contact opening 26 is provided extending over the polysilicon gate finger 25. The source metal plates 20 covering the regions 11 and 12 of the N- layer 3 are interrupted over the stripe of dielectric layer 18, and a metal gate finger 27 extends over the stripe of dielectric layer 18 contacting the polysilicon gate finger 25 through the elongated contact opening 26. As in the case of Fig. 2, the stripe of dielectric layer 18 is narrower than the P type elongated stripe 7, so that the source metal plates 21 contact the P type elongated stripe 7 along the elongated sides thereof. The P type elongated stripe 7 is wider than the P type elongated stripes 6 and 8 because while over the stripes 6 and 8 only the polysilicon gate finger 22 must be defined, over the stripe 7 it is necessary to define the polysilicon gate finger 25, the contact opening 26 in the dielectric layer 18 and the gate metal finger 27 between the two source metal plates 20.

Figs. 5 and 6 show in cross-sections parallel to the P type body stripes 9 the region of the chip where the P type body stripes 9 merges with the P type frame 5. The P type frame 5 is covered by a thick field oxide layer 28, over which a polysilicon gate ring 29 is provided; the polysilicon gate ring 29, which runs over the P type frame 5 surrounding all the P type body stripes 9 and the P type elongated stripes 6, 7, 8 is part of the polysilicon gate layer 17 (Fig. 6), and the polysilicon gate fingers 22 and 25 are connected at their ends with the polysilicon gate ring 29; thus, the polysilicon gate ring 29 and the polysilicon gate fingers 22, 25 form a mesh overlying the P type mesh 4. The dielectric layer 18 which covers the polysilicon gate layer 17 extends over the polysilicon gate ring 29, and forms a dielectric ring covering the polysilicon gate ring 29. A contact opening 30 is provided in the dielectric ring over the polysilicon gate ring 29, and a metal gate ring 31 runs over the dielectric ring to contact the underlying polysilicon gate ring 29; the metal gate finger 27 is also merged at its ends with the metal gate ring 31.

Thanks to the presence of the P type mesh 4 to which all the P type body stripes 9 are connected, all the P type regions (i.e. the P type frame 5, the P type elongated stripes 6, 7, 8 and the P type body stripes 9) can be biased at the same electric potential.

The P type frame 5 forms an edge structure of the power device chip.

The P type elongated stripes 6 and 8 are useful to avoid the necessity of providing too long P type body stripes; the polysilicon gate fingers 22 extending over the P type elongated stripes 6 and 8 allow a better distribution of the gate driving signal.

The provision of the metal gate finger 27 allows a better distribution of the gate driving signal. In this way, the gate resistance of the MOS-technology power device is greatly reduced.

Thanks to the presence of the P type elongated stripes 6, 7, 8 under the polysilicon gate fingers 22 and under the metal gate finger 27, a gate-drain parasitic capacitance is transformed into a gate-source capacitance, with an improvement of the dynamic performance. These P type elongated stripes also form barriers for the electric field from the drain toward the gate oxide layer when the junction diodes associated to the body stripes and to the common drain layer switches from a forward to a reverse bias.

For the manufacturing of the MOS-technology power device integrated structure, after the N- semiconductor layer 3 is formed over the N+ substrate 2, for example by means of epitaxial growth, a field oxide layer 32 is formed over the entire surface of the N- layer 3.

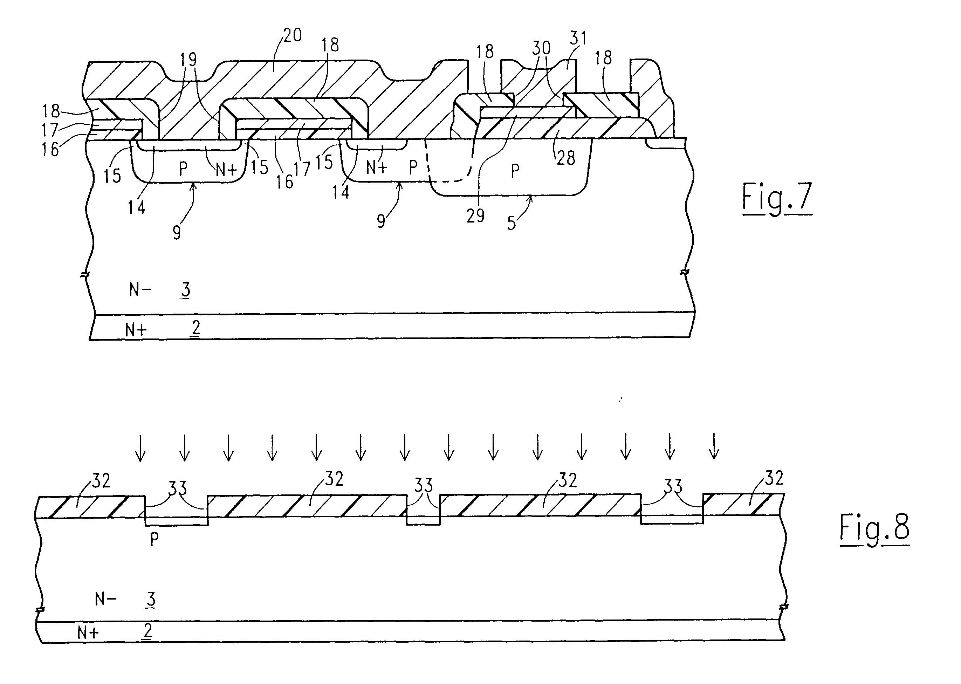

The field oxide layer 32 is selectively removed from the surface of the N- layer 3 by means of any known photolitographic process, to open windows 33. A P type dopant, for example boron or aluminium, is then selectively implanted into the N- layer 3 through the windows 33 in the field oxide layer 32 (Fig. 8). The use of aluminum is preferred when it is desired that the P type frame 5 and the P type elongated stripes extend deeply in the N- layer 3.

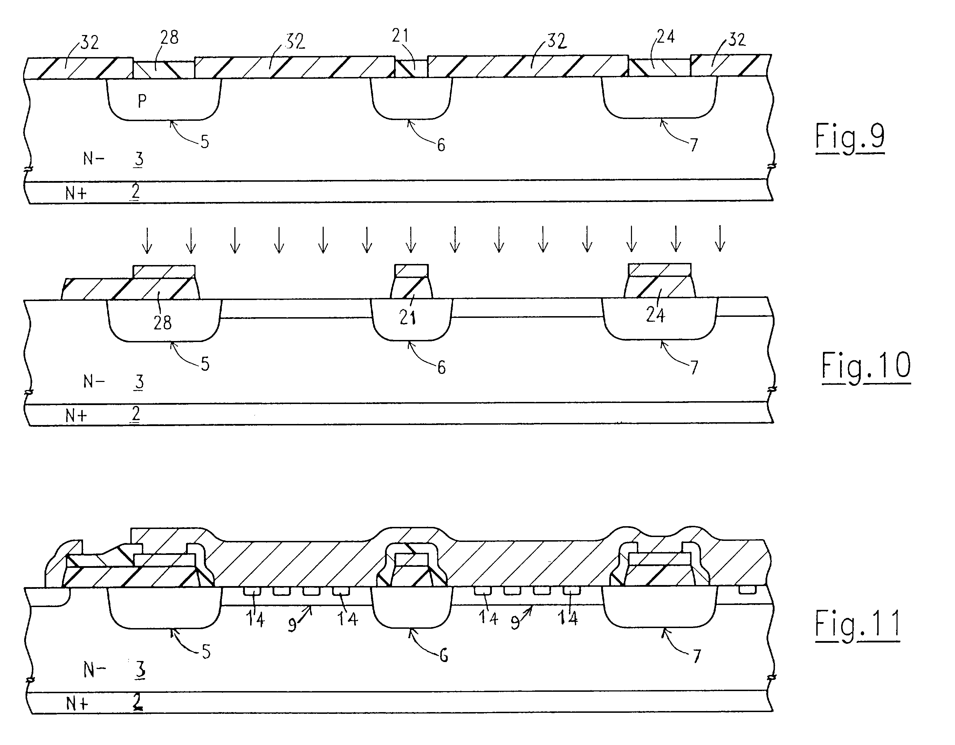

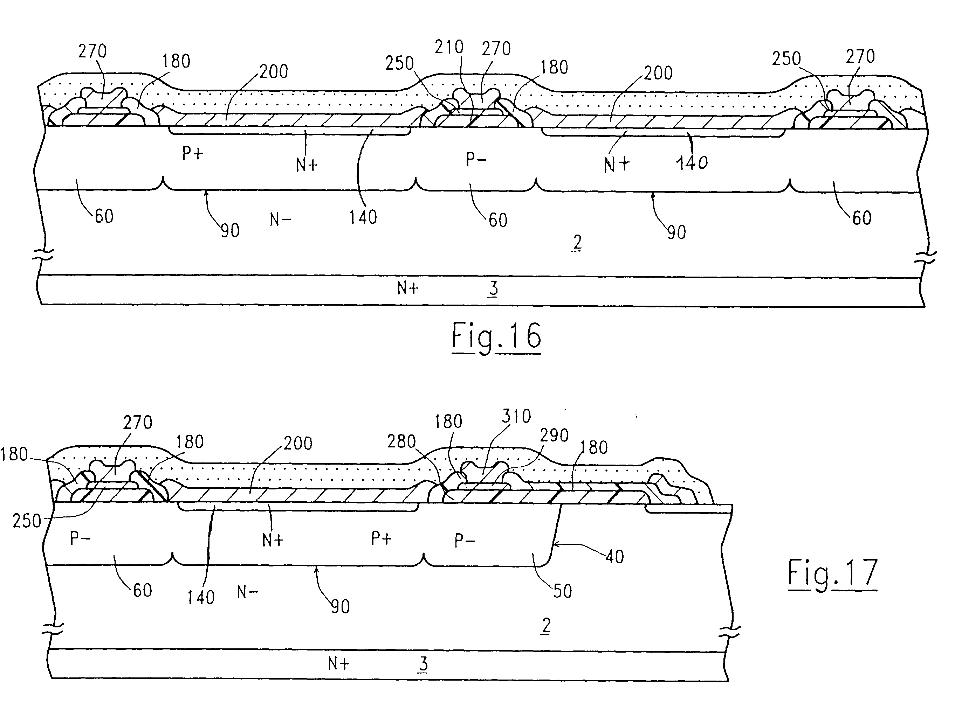

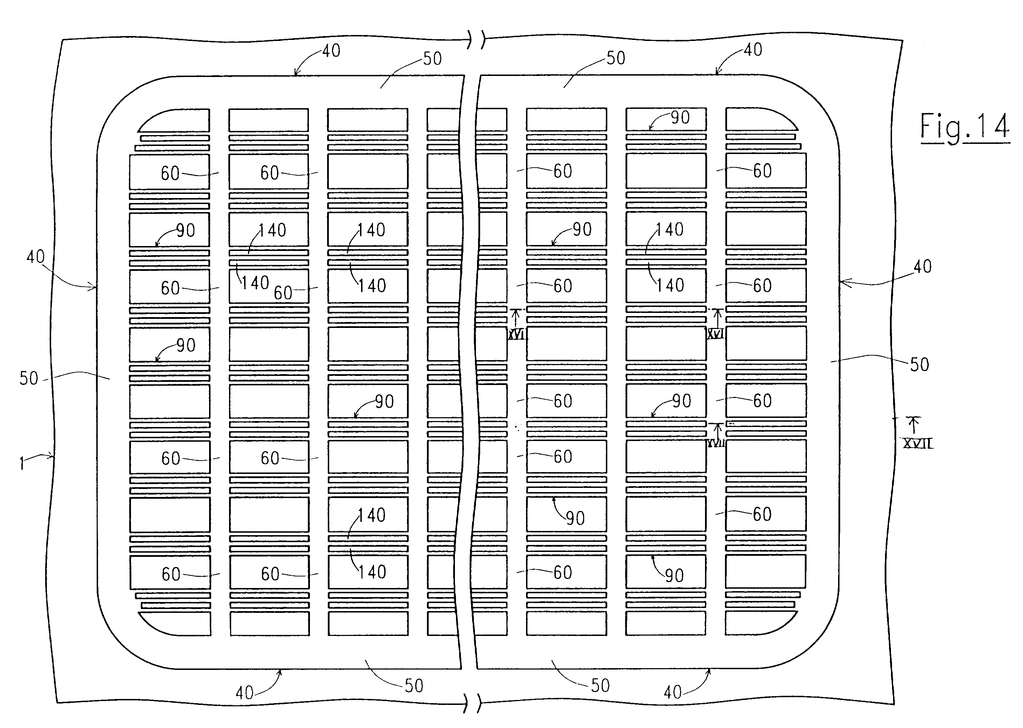

A thermal oxidation process is then performed to grow over the uncovered surface of the N- layer 3 (windows 33) an oxide layer with thickness equal to two to three times the thickness of the gate oxide layer 17 (to be formed in a later step). During the growth of the oxide, the P type dopant implanted in the previous step diffuses in the N- layer 3 to create the P type mesh 4 comprising the P type frame 5 and the P type elongated stripes 6, 7 and 8 (Figs. 9 and 12).

The remaining field oxide layer 32 is then completely eliminated from the active regions of the chip, where the elementary functional units of the power device are to be formed (i.e. in the area surrounded by the P type frame 5).

A thin oxide layer 16 is then formed, said layer forming the gate oxide of the MOS-technology power device and being two to three times thinner than the layer previously grown. A polysilicon gate layer is deposited over the whole surface of the power device. The gate oxide layer 16 and the polysilicon gate layer 17 are then selectively removed to define the polysilicon gate fingers and the polysilicon gate ring, and to open elongated windows over the N- layer 3 for the successive selective introduction of P type dopants for the body stripes 9.

A P type dopant is then implanted into the N- layer 3 through the elongated windows in the polysilicon and gate oxide layers to form the P type body stripes 9 (Figs. 10 and 13).

An N type dopant is then selectively introduced into the P type body stripes to form the source regions 14. A dielectric layer is formed over the entire surface of the chip, and it is selectively removed to open contact openings. A metal layer is formed over the dielectric layer, and it is selecticely etched to define the source metal plates 20, the gate metal finger 27 and the gate metal ring 31 (Fig. 11).

Fig. 14 is a schematic top-plan view of a MOS-technology power device chip showing a second embodiment of the present invention.

As in the previous embodiment, the chip 1 comprises an N+ semiconductor substrate 2 and an N- semiconductor layer 3 formed over the substrate 2 (Figs. 15 and 16). As in the case of Fig. 1, Fig. 14 is a top-plan view at the level of the surface of the N- layer 3.

A P type mesh 40 is formed in the N- layer 3; the P type mesh 40 comprises a P type annular frame 50 and a plurality of substantially parallel P type elongated stripes 60 extending between two opposite sides of the P type frame 50, the P type elongated stripes 60 being merged at their ends with the P type frame 50.

P type body stripes 90 extends substantially orthogonally to the P type elongated stripes 60 between adjacent P type stripes 60, and between the P type frame 50 and the first and last P ones of the P type elongated stripes 60. Inside each P type body stripe 90, two elongated N+ source stripes 140 extend for substantially the whole length of the body stripe 90.

As visible in perspective in Fig. 15, a conductive insulated gate layer comprising a thin gate oxide layer 160 and a polysilicon layer 170 extend over the N- layer 3 between the P type body stripes 90. The insulated gate layer slightly extends over the P type body stripes 90, more precisely it extends over channel portions 150 defined by the N+ source stripes 140. The polysilicon layer 170 forms the gate electrode of the MOS-technology power device, and when a proper bias voltage is applied to the polysilicon layer 170 an inversion channel is formed in the channel portions 150 of the P type body stripes 90. The polysilicon layer 170 is covered by a dielectric layer 180 in which elongated contact openings are provided over the P type body stripes 90, the elongated contact openings in the dielectric layer 180 extending substantially for the whole length of the P type body stripes 90. Source metal plates 200 cover the dielectric layer 180 and contact, through the elongated contact openings in the dielectric layer 180, the N+ source regions 140 and the P type body stripes 90. The source metal plates 200 completely cover the chip 1, except than over the P type elongated stripes 60.

Making now reference to Figs. 15 to 17, over the P type elongated stripes 60 a stripe 210 of a thick oxide layer is provided (having thickness approximately equal to two-three times the thickness of the gate oxide layer 160), extending for the whole length of the P type stripe 60. Over the stripe 210 of thick oxide, a stripe 250 of polysilicon layer is provided; the stripe 250 of polysilicon layer is part of the polysilicon layer 170 forming the gate electrode of the MOS-technology power device, and forms a polysilicon gate finger. The polysilicon gate finger 250 is covered by a stripe of the dielectric layer 180 in which an elongated contact opening 260 is provided extending over the polysilicon gate finger 250. The source metal plates 200 are interrupted over the stripe of dielectric layer 180, and a metal gate finger 270 extends over the stripe of dielectric layer 180 contacting the polysilicon gate finger 250 through the elongated contact opening 260.

Finally, Fig. 17 shows in cross-section the region of the chip where one of the P type body stripes 90 merges with the P type frame 50. The P type frame 50 is covered by a thick field oxide layer 280, over which a polysilicon gate ring 290 is provided; the polysilicon gate ring 290, which runs over the P type frame 50 surrounding all the P type body stripes 90 and the P type elongated stripes 60 is part of the polysilicon gate layer 170, and the polysilicon gate fingers 250 are connected at their ends with the polysilicon gate ring 290; thus, the polysilicon gate ring 290 and the polysilicon gate fingers 250 form a mesh overlying the P type mesh 40. The dielectric layer 180 which covers the polysilicon gate layer 170 extends over the polysilicon gate ring 290. An annular contact opening is provided in the dielectric layer 180 over the polysilicon gate ring 290, and a metal gate ring 310 runs over and contacts the underlying polysilicon gate ring 290; the metal gate fingers 270 are also merged at their ends with the metal gate ring 310. A passivation layer 320 (Figs. 16 and 17) covers the entire surface of the chip.

It is worth noting that even if the previous description was directed to an N channel power MOSFET, the present invention applies as well to P channel power MOSFETs (which simply involves a reversing of the conductivity types) or to Insulated Gate Bipolar Transistors (IGBT), in which the substrate is of the opposite conductivity type of the common drain layer 3.

## Claims

1. MOS-technology power device integrated structure comprising a plurality of elementary functional units formed in a semiconductor material layer (3) of a first conductivity type, the elementary functional units comprising body stripes (9;90) of a second conductivity type formed in said semiconductor material layer (3) and extending substantially parallel to each other and source regions (14;140) of the first conductivity type formed in the body stripes (9;90), a conductive gate layer (17;170) insulatively disposed over the semiconductor material layer (3) between the body stripes (9;90), the conductive gate layer comprising a polysilicon layer which is isolated from the underlying semiconductor material layer (3) by a first oxide layer (16;160), at least one first elongated stripe (7;60) of the second conductivity type formed in the semiconductor material layer (3) extending in a direction substantially orthogonal to the body stripes (9;90), the body stripes being divided by said at least one first elongated stripe (7;60) in two respective groups, a first conductive gate finger (25;250) connected to said conductive gate layer (17;170) insulatively extending over the at least one first elongated stripe (7;60), source metal plates (20;200) covering each group of parallel body stripes and contacting each body stripe of the group, said first conductive gate finger (25;250) being covered and contacted by a respective metal gate finger (27;270), characterized in that an annular frame region (5;50) of the second conductivity type is provided in the semiconductor material layer (3), the annular frame region surrounding the plurality of body stripes (9;90), the at least one first elongated stripe (7;60) being merged with the annular frame region (5;50) so to form a mesh (4;40), the body stripes (9;90) being merged with said mesh, and in that said first conductive gate finger (25;250) comprises a polysilicon finger which is isolated from the underlying first elongated stripe (7;60) by a second oxide layer (24;210) thicker than said first oxide layer (16;160).

2. MOS-technology power device according to claim 1, characterized in that a conductive gate ring (29;290) is insulatively disposed over the annular frame region (5;50), said first conductive gate finger (25;250) being connected to the conductive gate ring (29;290), and in that a metal gate ring (31;310) extends over and contacts the conductive gate ring (29;290), said metal gate finger (27;270) being connected to the metal gate ring (29;290).

3. MOS-technology power device according to claim 2, characterized in that said annular frame (5;50) forms an edge structure of the power device.

4. MOS-technology power device according to claim 3, characterised in that a plurality of first elongated stripes (60) is provided dividing the body stripes (90) into a respective plurality of groups of body stripes (90), the body stripes (90) having at least one end merged with a respective first elongated stripe (60) and another end merged with another respective first elongated stripe (60) or with the annular frame (50), each first elongated stripe (60) being insulatively covered by a respective first conductive gate finger (250) which is in turn covered and contacted by a respective metal gate finger (270).

5. MOS-technology power device according to claim 3, characterized in that said mesh (4) of the second conductivity type comprises at least one second elongated stripe (6,8) extending within the annular frame region (5) substantially orthogonally to the body stripes (9) and merged with said annular frame region (5), said at least one second elongated strips (6,8) being insulatively covered by a respective second conductive gate finger (22) connected to said conductive gate layer (17) and to said conductive gate ring (29), said second conductive gate finger (22) being in turn insulatively covered by said source metal plates (20).

6. MOS-technology power device according to claim 5, characterized in that a plurality of said second elongated stripes (6,8) is provided.

7. MOS-technology power device according to claim 6, characterized in that said second conductive gate finger (22) comprises a polysilicon gate finger which is insulated from the underlying second elongated stripe (6,8) by a third oxide layer (23) having the same thickness as said first oxide layer (16).

8. MOS-technology power device according to claim 6, characterized in that said second conductive gate finger (22) is insulated from the underlying second elongated stripe (6,8) by a fourth oxide layer (21) which is thicker than said first oxide layer (16).

9. MOS-technology power device according to anyone of the preceding claims, characterized in that each body stripe (90) includes two elongated source stripes (140) extending for substantially the whole length of the body stripe (90).

10. MOS-technology power device according to anyone of claims 1 to 3, characterized in that each body stripe (9) includes a plurality of source regions (14) intercalated in the longitudinal direction of the body stripe (9) with portions of the body stripe (9).

11. MOS-technology power device according to anyone of the preceding claims, characterized in that said semiconductor material layer (3) is superimposed over a semiconductor material substrate (2).

12. MOS-technology power device according to claim 11, characterized in that said semiconductor material substrate is of the first conductivity type.

13. MOS-technology power device according to claim 11, characterized in that said semiconductor material substrate is of the second conductivity type.

14. MOS-technology power device according to anyone of the preceding claims, characterized in that said first conductivity type is the N type, and said second conductivity type is the P type.

15. MOS-technology power device according to anyone of claims 1 to 13, characterized in that said first conductivity type is the P type, and said second conductivity type is the N type.

## Patentansprüche

1. MOS-Technologie-Leistungsvorrichtung in integrierter Struktur mit einer Mehrzahl von elementaren funktionalen Einheiten, die in einer Halbleitermaterialschicht (3) eines ersten Leitungstyps ausgebildet sind, wobei die elementaren funktionalen Einheiten Körperstreifen (9; 90) eines zweiten Leitungstyps, die in der Halbleitermaterialschicht (3) ausgebildet sind und sich im wesentlichen parallel zueinander erstrecken, und Sourcebereiche (14; 140) des ersten Leitungstyps, die in den Körperstreifen (9; 90) ausgebildet sind, aufweisen, einer leitenden Gateschicht (17; 170), die isoliert über der Halbleitermaterialschicht (3) zwischen den Körperstreifen (9; 90) angeordnet ist, wobei die leitende Gateschicht eine Polysiliziumschicht, die von der darunterliegenden Halbleitermaterialschicht (3) durch eine erste Oxidschicht (16; 160) getrennt ist, aufweist, mindestens einem ersten länglichen Streifen (7; 60) des zweiten Leitungstyps, der in der Halbleitermaterialschicht (3), sich in einer Richtung, die im wesentlichen senkrecht zu den Körperstreifen (9; 90) ist, erstreckend, ausgebildet ist, wobei die Körperstreifen durch den mindestens einen länglichen Streifen (7; 60) in zwei entsprechende Gruppen geteilt sind, einem ersten leitenden Gatefinger (25; 250), der mit der leitenden Gateschicht (17; 170) verbunden ist und sich isoliert über den mindestens einen ersten länglichen Streifen (7; 60) erstreckt, Sourcemetallplatten (20; 200), die jede Gruppe von parallelen Körperstreifen bedecken und jeden Körperstreifen der Gruppe kontaktieren, wobei der erste leitende Gatefinger (25; 250) durch einen entsprechenden Metallgatefinger (27; 270) bedeckt und kontaktiert ist, dadurch gekennzeichnet, daß ein ringförmiger Rahmenbereich (5; 50) des zweiten Leitungstyps in der Halbleitermaterialschicht (3) vorgesehen ist, wobei der ringförmige Rahmenbereich die Mehrzahl von Körperstreifen (9; 90) umgibt, der mindestens eine längliche Streifen (7; 60) mit dem ringförmigen Rahmenbereich (5; 50) derart verbunden ist, daß eine Masche (4; 40) gebildet wird, wobei die Körperstreifen (9; 90) mit der Masche verbunden sind, und daß der erste leitende Gatefinger (25; 250) einen Polysiliziumfinger aufweist, der von dem darunterliegenden ersten länglichen Streifen (7; 60) durch eine zweite Oxidschicht (24; 210), die dicker als die erste Oxidschicht (16; 160) ist, getrennt ist.

2. MOS-Technologie-Leistungsvorrichtung nach Anspruch 1, dadurch gekennzeichnet,
daß ein leitender Gatering (29; 290) isoliert über dem ringförmigen Rahmenbereich (5; 50) angeordnet ist, wobei der erste leitende Gatefinger (25; 250) mit dem leitenden Gatering (29; 290) verbunden ist, und
daß ein Metall-Gatering (31; 310) sich über dem leitenden Gatering (29; 290) erstreckt und diesen kontaktiert, wobei der Metall-Gatefinger (27; 270) mit dem Metall-Gatering (29; 290) verbunden ist.

3. MOS-Technologie-Leistungsvorrichtung nach Anspruch 2, dadurch gekennzeichnet,
daß der ringförmige Rahmen (5; 50) eine Randstruktur der Leistungsvorrichtung bildet.

4. MOS-Technologie-Leistungsvorrichtung nach Anspruch 3, dadurch gekennzeichnet,
daß eine Mehrzahl von ersten länglichen Streifen (60), die die Körperstreifen (90) in eine entsprechende Mehrzahl von Gruppen von Körperstreifen (90) unterteilt, vorgesehen ist, wobei die Körperstreifen (90) mindestens ein Ende, das mit einem entsprechenden ersten länglichen Streifen (60) verbunden ist, und ein anderes Ende, das mit einem anderen entsprechenden ersten länglichen Streifen (60) oder mit dem ringförmigen Rahmen (50) verbunden ist, aufweisen, wobei jeder erste längliche Streifen (60) isoliert durch einen entsprechenden ersten leitenden Gatefinger (250) bedeckt ist, der wiederum durch einen entsprechenden Metall-Gatefinger (270) bedeckt und kontaktiert ist.

5. MOS-Technologie-Leistungsvorrichtung nach Anspruch 3, dadurch gekennzeichnet,
daß die Masche (4) des zweiten Leitungstyps mindestens einen zweiten länglichen Streifen (6, 8), der sich innerhalb des ringförmigen Rahmenbereiches (5) im wesentlichen senkrecht zu dem Körperstreifen (9) erstreckt und mit dem ringförmigen Rahmenbereich (5) verbunden ist, aufweist, wobei der mindestens eine zweite längliche Streifen (6, 8) isoliert durch einen entsprechenden zweiten leitenden Gatefinger (22), der mit der leitenden Gateschicht (17) und mit dem leitenden Gatering (29) verbunden ist, bedeckt ist, wobei der zweite leitende Gatefinger (22) wiederum isolierend durch die Source-Metallplatten (20) bedeckt ist.

6. MOS-Technologie-Leistungsvorrichtung nach Anspruch 5, dadurch gekennzeichnet,
daß eine Mehrzahl der zweiten länglichen Streifen (6, 8) vorgesehen ist.

7. MOS-Technologie-Leistungsvorrichtung nach Anspruch 6, dadurch gekennzeichnet,
daß der zweite leitende Gatefinger (22) einen Polysilizium-Gatefinger aufweist, der von dem darunterliegenden zweiten länglichen Streifen (6, 8) durch eine dritte Oxidschicht (23), die dieselbe Dicke wie die erste Oxidschicht (16) aufweist, isoliert ist.

8. MOS-Technologie-Leistungsvorrichtung nach Anspruch 6, dadurch gekennzeichnet,
daß der zweite leitende Gatefinger (22) von dem darunterliegenden zweiten länglichen Streifen (6, 8) durch eine vierte Oxidschicht (21), die dicker als die erste Oxidschicht (16) ist, isoliert ist.

9. MOS-Technologie-Leistungsvorrichtung nach einem der vorhergehenden Ansprüche, dadurch gekennzeichnet,
daß jeder Körperstreifen (90) zwei längliche Sourcestreifen (140), die sich über im wesentlichen die gesamte Länge des Körperstreifens (90) erstrecken, enthält.

10. MOS-Technologie-Leistungsvorrichtung nach einem der Ansprüche 1 bis 3, dadurch gekennzeichnet,
daß jeder Körperstreifen (9) eine Mehrzahl der Sourcebereiche (14) enthält, zwischen die in der Längsrichtung des Körperstreifens (9) Abschnitte des Körperstreifens (9) gefügt sind.

11. MOS-Technologie-Leistungsvorrichtung nach einem der vorhergehenden Ansprüche, dadurch gekennzeichnet,
daß die Halbleitermaterialschicht (3) über ein Halbleitermaterialsubstrat (2) überlagert ist.

12. MOS-Technologie-Leistungsvorrichtung nach Anspruch 11, dadurch gekennzeichnet,
daß das Halbleitermaterialsubstrat vom ersten Leitungstyp ist.

13. MOS-Technologie-Leistungsvorrichtung nach Anspruch 11, dadurch gekennzeichnet,
daß das Halbleitermaterialsubstrat vom zweiten Leitungstyp ist.

14. MOS-Technologie-Leistungsvorrichtung nach einem der vorhergehenden Ansprüche, dadurch gekennzeichnet,
daß der erste Leitungstyp der N-Typ und der zweite Leitungstyp der P-Typ ist.

15. MOS-Technologie-Leistungsvorrichtung nach einem der Ansprüche 1 bis 13, dadurch gekennzeichnet,
daß der erste Leitungstyp der P-Typ und der zweite Leitungstyp der N-Typ ist.

## Revendications

1. Structure intégrée de dispositif de puissance à technologie métal-oxyde-semiconducteur (MOS) comprenant une pluralité d'unités fonctionnelles élémentaires formées dans une couche de matériau semiconducteur (3) d'un premier type de conductivité, les unités fonctionnelles élémentaires comprenant des bandes de corps (9; 90) d'un second type de conductivité formées dans ladite couche de matériau semiconducteur (3) et s'étendant sensiblement parallèlement les unes aux autres et des régions de source (14; 140) du premier type de conductivité formées dans les bandes de corps (9; 90), une couche de grille conductrice (17; 170) disposée de façon isolante sur la couche de matériau semiconducteur (3) entre les bandes de corps (9; 90), la couche de grille conductrice comprenant une couche de silicium polycristallin qui est isolée de la couche de matériau semiconducteur (3) sous-jacente par une première couche d'oxyde (16; 160), au moins une première bande allongée (7; 60) du second type de conductivité formée dans la couche de matériau semiconducteur (3) s'étendant dans une direction sensiblement orthogonale aux bandes de corps (9; 90), les bandes de corps étant divisées en deux groupes respectifs par ladite première bande allongée (7; 60) au nombre d'au moins une, un premier doigt de grille conducteur (25; 250) connecté à ladite couche de grille conductrice (17; 170) s'étendant de façon isolante sur la première bande allongée (7; 60) au nombre d'au moins une, des plaques métalliques de source (20; 200) recouvrant chaque groupe de bandes de corps parallèles en établissant un contact avec chaque bande de corps du groupe, ledit premier doigt de grille conducteur (25; 250) étant recouvert par un doigt de grille métallique respectif (27; 270) qui est en contact avec celui-ci, caractérisée en ce qu'une région d'encadrement annulaire (5; 50) du second type de conductivité est prévue dans la couche de matériau semiconducteur (3), la région d'encadrement annulaire entourant la pluralité de bandes de corps (9; 90), la première bande allongée (7; 60) au nombre d'au moins une étant fusionnée avec la région d'encadrement annulaire (5; 50) afin de former une maille (4; 40), les bandes de corps (9; 90) étant fusionnées avec ladite maille, et en ce que ledit premier doigt de grille conducteur (25; 250) comprend un doigt de silicium polycristallin qui est isolé de la première bande allongée (7; 60) sous-jacente par une deuxième couche d'oxyde (24; 210) plus épaisse que ladite première couche d'oxyde (16; 160).

2. Dispositif de puissance à technologie métal-oxyde-semiconducteur (MOS) selon la revendication 1, caractérisé en ce qu'un anneau de grille conducteur (29; 290) est disposé de façon isolante sur la région d'encadrement annulaire (5; 50), ledit premier doigt de grille conducteur (25; 250) étant connecté à l'anneau de grille conducteur (29; 290), et en ce qu'un anneau de grille métallique (31; 310) s'étend sur l'anneau de grille conducteur (29; 290) et est en contact avec celui-ci, ledit doigt de grille métallique (27; 270) étant connecté à l'anneau de grille conducteur (29; 290).

3. Dispositif de puissance à technologie métal-oxyde-semiconducteur (MOS) selon la revendication 2, caractérisé en ce que ledit encadrement annulaire (5; 50) forme une structure de bord du dispositif de puissance.

4. Dispositif de puissance à technologie métal-oxyde-semiconducteur (MOS) selon la revendication 3, caractérisé en ce qu'une pluralité de premières bandes allongées (60) est prévue, divisant les bandes de corps (90) en une pluralité respective de groupes de bandes de corps (90), une extrémité au moins dès bandes de corps (90) étant fusionnée avec une première bande allongée respective (60) et une autre extrémité étant fusionnée avec une autre première bande allongée respective (60) ou avec l'encadrement annulaire (50), chaque première bande allongée (60) étant recouverte de façon isolante par un premier doigt de grille conducteur respectif (250) qui est lui-même recouvert par un doigt de grille métallique respectif (270) et en contact avec celui-ci.

5. Dispositif de puissance à technologie métal-oxyde-semiconducteur (MOS) selon la revendication 3, caractérisé en ce que ladite maille (4) du second type de conductivité comprend au moins une deuxième bande allongée (6, 8) s'étendant à l'intérieur de la région d'encadrement annulaire (5) sensiblement orthogonalement aux bandes de corps (9) et fusionnée avec ladite région d'encadrement annulaire (5), ladite deuxième bande allongée (6, 8) au nombre d'au moins une étant recouverte de façon isolante par un deuxième doigt de grille conducteur respectif (22) connecté à ladite couche de grille conductrice (17) et audit anneau de grille conducteur (29), ledit deuxième doigt de grille conducteur (22) étant lui-même recouvert de façon isolante par lesdites plaques métalliques de source (20).

6. Dispositif de puissance à technologie métal-oxyde-semiconducteur (MOS) selon la revendication 5, caractérisé en ce qu'est prévue une pluralité desdites deuxièmes bandes allongées (6, 8).

7. Dispositif de puissance à technologie métal-oxyde-semiconducteur (MOS) selon la revendication 6, caractérisé en ce que ledit deuxième doigt de grille conducteur (22) comprend un doigt de grille de silicium polycristallin qui est isolé de la deuxième bande allongée (6, 8) sous-jacente par une troisième couche d'oxyde (23) présentant la même épaisseur que ladite première couche d'oxyde (16).

8. Dispositif de puissance à technologie métal=oxyde-semiconducteur (MOS) selon la revendication 6, caractérisé en ce que ledit deuxième doigt de grille conducteur (22) est isolé de la deuxième bande allongée (6, 8) sous-jacente par une quatrième couche d'oxyde (21) qui est plus épaisse que ladite première couche d'oxyde (16).

9. Dispositif de puissance à technologie métal-oxyde-semiconducteur (MOS) selon l'une quelconque des revendications précédentes, caractérisé en ce que chaque bande de corps (90) comporte deux bandes de source allongées (140) s'étendant sur sensiblement toute la longueur de la bande de corps (90).

10. Dispositif de puissance à technologie métal-oxyde-semiconducteur (MOS) selon l'une quelconque des revendications 1 à 3, caractérisé en ce que chaque bande de corps (9) comporte une pluralité de régions de source (14) intercalées dans la direction longitudinale de la bande de corps (9) avec des parties de la bande de corps (9).

11. Dispositif de puissance à technologie métal-oxyde-semiconducteur (MOS) selon l'une quelconque des revendications précédentes, caractérisé en ce que ladite couche de matériau semiconducteur (3) est superposée sur un substrat de matériau semiconducteur (2).

12. Dispositif de puissance à technologie métal-oxyde-semiconducteur (MOS) selon la revendication Il, caractérisé en ce que ledit substrat de matériau semiconducteur est du premier type de conductivité.

13. Dispositif de puissance à technologie métal-oxyde-semiconducteur (MOS) selon la revendication 11, caractérisé en ce que ledit substrat de matériau semiconducteur est du second type de conductivité.

14. Dispositif de puissance à technologie métal-oxyde-semiconducteur (MOS) selon l'une quelconque des revendications précédentes, caractérisé en ce que ledit premier type de conductivité est le type N, et ledit second type de conductivité est le type P.

15. Dispositif de puissance à technologie métal-oxyde-semiconducteur (MOS) selon l'une quelconque des revendications 1 à 13, caractérisé en ce que ledit premier type de conductivité est le type P, et ledit second type de conductivité est le type N.
